# FASCICULE DE BREVET EUROPEEN

(11) **EP 0 334 708 B1**
(45) Date de publication et mention de la délivrance du brevet: **25.05.1994**
(21) Numéro de dépôt: 89400664.2
(22) Date de dépôt: 10.03.1989
(51) Int. Cl.: H01L 23/40, F16B 2/00, F16B 21/12

(54) **Dispositif de fixation à pression de deux pièces l'une à l'autre et boîtier de circuit intégré mettant en oevre ce dispositif**
Anordnung zur Befestigung von zwei Stücken durch Anpressen und Gehäuse für ein integriertes Schaltungsbauelement mit dieser Anordnung
Device for joining two pieces together under pressure and integrated circuit package using said device

(30) Priorité: 22.03.1988 FR 8803675
(43) Date de publication de la demande: 27.09.1989
(73) Titulaire: BULL S.A., 92800 Puteaux (FR)
(72) Inventeur: Dehaine, Gérard, F-75016 Paris (FR)
(74) Mandataire: Denis, Hervé

(56) Documents cités:
- FR-A- 2 306 783
- FR-A- 2 326 040

## Description

L'invention se rapporte à un dispositif de fixation à pression de deux pièces l'une à l'autre et à un boîtier de circuit intégré de haute densité mettant en oeuvre ce dispositif.

On trouvera par exemple dans le document FR-A-2 326 040 la description d'un dispositif de fixation amovible à pression de deux pièces superposées l'une à l'autre par l'intermédiaire d'au moins une colonne fixée à l'une des pièces et d'un dispositif de pression s'appuyant sur l'autre pièce et sur un dispositif de connexion amovible à la colonne. Dans ce dispositif de fixation, le dispositif de pression est formé de ressorts hélicoïdaux exerçant sur les deux pièces une pression sensiblement constante, et le dispositif de connexion amovible est formé d'une traverse serrée par des vis contre des tiges entretoises.

Pour la fixation des deux pièces, il faut les assembler correctement avec le dispositif de pression et le dispositif de connexion et faire en sorte que le dispositif de pression soit dûment comprimé pour exercer les forces désirées. On comprend que la mise en place du dispositif de pression est d'autant plus difficile que les pièces sont de petites dimensions et que la pression de fixation est élevée. D'autre part, il est souvent souhaitable que la fixation soit amovible. Evidemment, le démontage d'un dispositif de fixation à pression rencontre le même inconvénient que le montage. Un autre inconvénient s'y ajoute lorsqu'au moins une des pièces a été soumise à des conditions qui ont fait évoluer le dispositif de fixation vers un autre état. Par exemple, la chaleur exercée sur au moins l'une des deux pièces peut les déformer ou corroder certaines parties du dispositif de fixation et rendre difficile son démontage. La fixation amovible à pression d'un radiateur sur un boîtier de circuit intégré à haute densité cumule ces inconvénients et sera donc pris comme exemple d'illustration de l'invention.

En effet, tandis que la taille des circuits intégrés ne cesse de croître et dépasse actuellement le centimètre de côté, les boîtiers sont conçus pour être de plus en plus petits. Par exemple, dans des boîtiers tels que décrits dans les demandes de brevet français n^{o} 87 13416 et 87 13417 de la demanderesse, la plaque d'interface pour l'évacuation de la chaleur a une taille deux à trois fois plus grande que celle du circuit intégré, soit environ 25 millimètres de côté. La fixation d'un radiateur se fait ordinairement sur une colonne axiale de la plaque. Diverses formes d'amovibilité ont déjà été envisagées, notamment le collage et le vissage.

Cependant, la colle ajoute une résistance thermique au trajet d'évacuation de la chaleur et le décollage est une opération délicate. Quant au vissage, il est malaisé pour des pièces aussi petites et il assure difficilement et à coût élevé le contact uniforme aux pressions requises du radiateur contre la plaque d'interface du boîtier. En outre, le chauffage des deux pièces peut rendre difficile le desserrage au bout d'un certain temps. Un dispositif de fixation à pression s'avérerait profitable pour assurer un contact uniforme sous une pression prédéterminée du radiateur contre la plaque d'interface du boîtier, mais on a vu auparavant qu'un tel dispositif de fixation complique à la fois la structure et les opérations de montage et de démontage.

Une autre approche pour le refroidissement de circuits intégrés consiste à appliquer un seul et même radiateur sur un ensemble de circuits intégrés montés sur une carte de circuits imprimés. Le radiateur est donc fixé amoviblement sur des pieux solidaires de la carte. Il est donc aussi souhaitable dans ce cas d'avoir des dispositifs de fixation simples et efficaces, et dont l'amovibilité est aisée quelles que soient les conditions d'utilisation des pièces et leur évolution dans le temps.

L'emploi d'éléments à mémoire de forme dans un dispositif de fixation amovible à pression est connu du document FR-A-2 306 783. Cependant, ce dispositif de fixation se rapporte au raccordement bout à bout d'éléments tubulaires.

L'invention a pour objet un dispositif de fixation à pression de deux pièces l'une à l'autre, ayant une structure simple et procurant une fixation amovible aisée et indépendante des conditions d'utilisation des pièces ou de leur évolution dans le temps.

L'invention a pour objet un dispositif de fixation l'une à l'autre de deux pièces superposées par l'intermédiaire d'une colonne fixée à l'une des pièces et d'un dispositif de pression s'appuyant sur l'autre pièce et sur un dispositif amovible de connexion à la colonne, caractérisé en ce que le dispositif de pression inclut un élément à mémoire de forme pouvant se trouver dans un état rétracté, et le dispositif de connexion peut être libéré de la colonne lorsque l'élément à mémoire de forme est dans son état rétracté.

En corollaire, l'invention a aussi pour objet un boîtier de circuit intégré de haute densité comprenant un radiateur et une plaque d'interface portant le circuit intégré, et un dispositif de fixation du radiateur à la plaque d'interface tel que défini précédemment.

Les caractéristiques et avantages de l'invention ressortiront de la description qui suit, donnée à titre d'exemple et faite en référence aux dessins annexés.

Dans les dessins :
- la figure 1 est une vue en coupe d'un dispositif de fixation conforme à l'invention, exercant dans son état stable la fixation d'un radiateur à la plaque d'interface d'un boîtier de circuit intégré à haute densité vu de côté et représenté schématiquement ;
- la figure 2 est une vue similaire à la figure 1, illustrant le dispositif de fixation dans son état favorable à la déconnexion du radiateur ; et
- les figures 3A, 3B et 3C illustrent divers états du ressort à mémoire de forme illustré dans les figures 1 et 2.

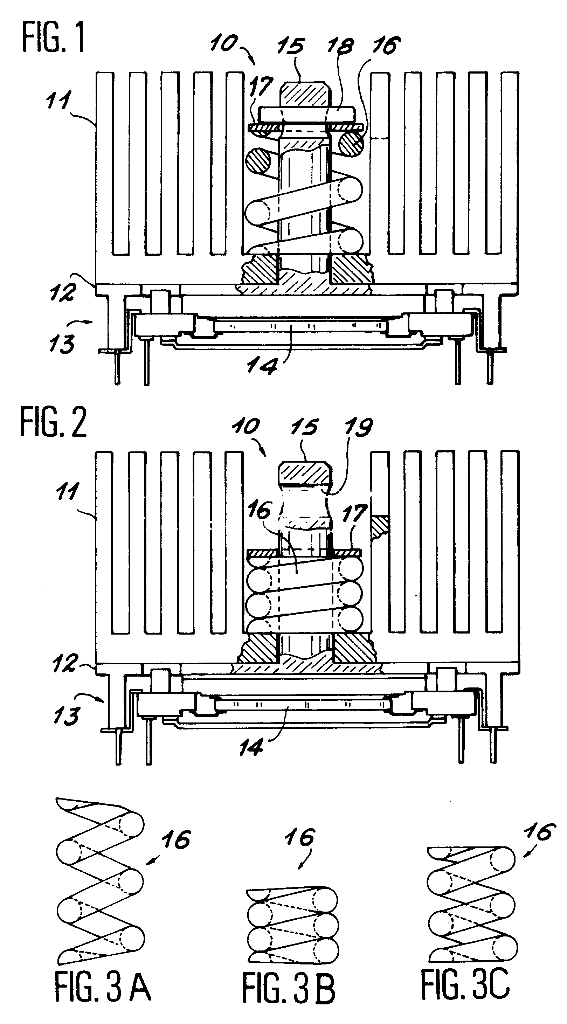

Les figures 1 et 2 illustrent un exemple de réalisation préférée conforme à l'invention d'un dispositif de fixation à pression 10 de deux pièces 11, 12 l'une à l'autre, constituées respectivement par le radiateur 11 monté sur la plaque d'interface 12 d'un boîtier 13 pour un circuit intégré de haute densité 14. Le boîtier 13 illustré correspond à celui décrit dans la demande de brevet n^{o} 87 13417 de la demanderesse. Selon cet exemple, la plaque 12 sert à la fois de support du circuit intégré 14 et d'élément d'évacuation de la chaleur dissipée par le circuit intégré. La pièce 12 est par exemple une plaque massive à base de cuivre sensiblement carrée de 25 millimètres de côté. La plaque 12 est pourvue d'une colonne axiale 15 pour la fixation du radiateur à ailettes 11. Le dispositif de fixation à pression 10 comprend un dispositif de pression 16 ayant la forme d'un ressort hélicoidal et un dispositif de connexion amovible composé d'une rondelle 17, d'une goupille 18 et d'un trou 19 dans la colonne 15 pour la goupille 18. Dans l'exemple considéré, la colonne 15 avait 5 millimètres de diamètre et le ressort 16 était un fil de 3 millimètres de diamètre enroulé sur trois spires ayant un diamètre moyen de 11 millimètres et exerçait en position de travail telle qu'illustrée dans la figure 1 une pression P = 150 Newtons sur la base du radiateur 11 contre la plaque 12 pour une extension d'environ 20 millimètres.

Selon l'invention, le ressort 16 est fait d'un matériau à mémoire de forme. Les figures 3A, 3B et 3C illustrent les caractéristiques du ressort 16 utilisé pour le dispositif de fixation 10. Dans cet exemple, le ressort 16 est fait à base de titane et de nickel. La figure 3A illustre le ressort dans son état stable, librement déployé, correspondant à la phase austénitique du matériau à mémoire de forme. La figure 3B illustre le ressort 16 rétracté, dans sa phase martensitique. Le matériau choisi avait une température de transition Ms de 213 K. Autrement dit, l'état du ressort 16 illustré dans la figure 3B correspond à une température inférieure à 213 K, tandis que l'état librement déployé illustré dans la figure 3A correspond à une température supérieure à 213 K, et inférieure à 423 K qui est la température maximale pour obtenir la mémoire de forme. La figure 3C illustre l'état du ressort 16 comprimé dans sa phase austénitique pour exercer la pression prédéterminée quand il est monté dans le dispositif de fixation 10 tel que représenté sur la figure 1.

Le montage et le démontage du radiateur 11 sur le boîtier 13 va maintenant être illustré en référence aux figures 1 à 3. En référence à la figure 2, le radiateur 11 est enfilé autour de la colonne 15 jusqu'à venir en contact avec la plaque 12 du boîtier 13. Le ressort 16 dans son état représenté sur la figure 3A est ensuite disposé coaxialement à la colonne 15. Le ressort 16 est alors soumis à une température inférieure à sa température de transition Ms pour le mettre dans sa phase martensitique et obtenir son état rétracté tel que représenté sur les figures 2 et 3B. La basse température peut être obtenue par exemple d'une bombe aérosol cryogénique qui offre l'avantage de la commodité d'emploi, de transport et de manipulation. La rondelle 17 est posée sur le ressort 16 et la goupille 18 est introduite dans le trou 19 de la colonne 15. Cette introduction se fait naturellement sans effort et aisément. Sous l'effet de la température ambiante le ressort revient dans son état stable austénitique et prend ainsi la position de travail représentée sur les figures 1 et 3C. Pour le démontage, on applique sur le ressort 16 représenté sur la figure 1 un aérosol cryogénique qui lui fait prendre l'état martensitique représenté sur la figure 2. On enlève ainsi facilement la goupille 18 avant que le ressort 16 retourne à son état austénitique qui lui donnera la forme librement détendue représentée sur la figure 3A.

Cette description suggère à l'évidence toutes les variantes possibles de réalisation d'un dispositif de fixation amovible à pression conforme à l'invention. Par exemple, le dispositif de pression 16 peut être complexe et utiliser divers éléments de pression sous diverses formes. Il peut suffire, selon leur agencement, qu'au moins l'un des éléments de pression soit fait d'un matériau à mémoire de forme. Compte tenu de la grande variété de matériaux à mémoire de forme, le dispositif de pression peut avoir une autre forme que celle illustrée et présenter des caractéristiques tout à fait différentes, pour autant qu'il remplit une fonction similaire à celle décrite. D'autre part, le dispositif de connexion amovible peut être évidemment quelconque, à condition qu'il permette la libération du dispositif de pression 16 à partir de son état comprimé lors du démontage des deux pièces 11 et 12. On pourrait ainsi remplacer la rondelle 17 et la goupille 18 par un anneau escamotable par exemple.

## Revendications

1. Dispositif de fixation (10) l'une à l'autre de deux pièces superposées (11, 12) par l'intermédiaire d'une colonne (15) fixée à l'une des pièces et d'un dispositif de pression (16) s'appuyant sur l'autre pièce et sur un dispositif (17, 18, 19) amovible de connexion à la colonne, caractérisé en ce que le dispositif de pression inclut un élément à mémoire de forme pouvant se trouver dans un état rétracté, et en ce que le dispositif de connexion peut être libéré de la colonne lorsque l'élément à mémoire de forme est dans son état rétracté.

2. Dispositif selon la revendication 1, caractérisé en ce que le dispositif de connexion comprend une goupille (18) traversant la colonne (15) et une rondelle (17) enfilée autour de la colonne.

3. Dispositif selon la revendication 1 ou 2, caractérisé en ce que le dispositif de pression (16) est un ressort hélicoïdal fait d'un matériau à mémoire de forme et entourant la colonne.

4. Boîtier (13) de circuit intégré de haute densité (14) comprenant un radiateur (11) et une plaque d'interface (12) portant le circuit intégré, et un dispositif de fixation du radiateur à la plaque d'interface tel que défini par l'une des revendications 1 à 3.

## Claims

1. Device for fastening (10) to each other two super-imposed components (11, 12) by the intermediary of a column (15) fastened to one of the components and of a pressure device (16) resting on the other component and on a removable device (17, 18, 19) for connection to the column, characterised in that the pressure device includes an element with shape memory, able to be in a retracted state, and in that the connection device can be freed from the column when the element with shape memory is in its retracted state.

2. Device according to claim 1, characterised in that the connection device comprises a keeper pin (18) passing through the column (15) and a washer (17) slipped around the column.

3. Device according to claim 1 or 2, characterised in that the pressure device is a helical spring (16) made of a material with shape memory and surrounding the column.

4. Casing (13) for a high density integrated circuit (14) comprising a heatsink (11) and an interface plate (12) carrying the integrated circuit, and a device for fastening the heatsink to the interface plate such as defined by one of claims 1 to 3.

## Patentansprüche

1. Befestigungsvorrichtung (10), um zwei übereinanderliegende Teile (11, 12) mittels eines Stabes (15), der an einem der Teile befestigt ist, und einer Druckvorrichtung (16), die sich am anderen Teil sowie an einer abnehmbaren Verbindungsvorrichtung (17, 18, 19) des Stabes abstützt, aneinander zu befestigen, dadurch gekennzeichnet, daß die Druckvorrichtung ein Element mit Formerinnerungsvermögen beinhaltet, das sich in einem zurückgezogenen Zustand befinden kann, und daß die Verbindungsvorrichtung vom Stab gelöst werden kann, wenn das Element mit Formerinnerungsvermögen sich in seinem zurückgezogenen Zustand befindet.

2. Vorrichtung nach Anspruch 1, dadurch gekennzeichnet, daß die Verbindungsvorrichtung einen Stift (18) enthält, der den Stab (15) durchquert, und eine Scheibe (17), die auf den Stab aufgesteckt ist.

3. Vorrichtung nach Anspruch 1 oder 2, dadurch gekennzeichnet, daß die Druckvorrichtung (16) eine den Stab umgebende Schraubenfeder ist, die aus einem Material mit Formerinnerungsvermögen besteht.

4. Gehäuse (13) einer hochintegrierten Schaltung (14), mit einem Kühlkörper (11), einer Zwischenplatte (12), die die integrierte Schaltung trägt, sowie einer Befestigungsvorrichtung nach einem der Ansprüche 1 bis 3 zum Befestigen des Kühlkörpers an der Zwischenplatte.
